# EUROPEAN PATENT APPLICATION

(11) **EP 1 239 447 A1**
(43) Date of publication of application: **11.09.2002**
(21) Application number: 02075652.4
(22) Date of filing: 18.02.2002
(51) Int. Cl.: G09G 3/36, G02F 1/1335

(54) **Flat panel display**

(30) Priority: 02.03.2001 US 798097
(71) Applicant: EASTMAN KODAK COMPANY, Rochester, New York 14650-2201 (US)
(72) Inventor: Freidhoff, Henry R, Rochester, New York 14650-2201 (US)
(74) Representative: Nunney, Ronald Frederick Adolphe

(57) **Abstract**

A display (20) including at least two distinct regions. One region (22) where colored sub-pixels are grouped to form full colored pixels and at least one other region (24) where monochromatic pixels at the same spacing as the sub-pixels in the full color region are used to display characters. The resulting pixel resolution in the monochromatic region therein being greater than the pixel resolution in full color region of the display in at least one direction.

## Description

The present invention relates generally to displays which have at least two regions, one displaying images and the other displaying characters.

Applications for full color displays often have requirements for displaying characters in or near the full color images. Typically, the acceptable resolution for the characters is greater than the acceptable resolution needed for the companion full color images. Thus the pixel to pixel distance is reduced in the entire display area to increase resolution for the characters or a separate higher resolution display is used for the character data. Examples of such displays would be a picture telephone with characters displayed below the image, a television with stock or message data below the screen, and a camera view finder or display with characters displayed around the image.

Many of the preferred technologies for these full color displays such as liquid crystal displays (LCDs), light emitting diode (LED) displays, and organic light emitting diode (OLED) displays use additive color sub-pixels. The manufacture of such displays includes the use of lithographic processes that increase in cost and difficulty as the sub-pixel to sub-pixel spacing is reduced. Thus, the cost of adequately displaying characters as well as images is increased by either increasing the resolution of the entire display or by displaying the characters on a separate higher resolution display.

It is an object of the present invention to provide regions on a full color display where monochromatic characters can be displayed with greater resolution than that of the full color regions.

This object is achieved by a display comprising:
a) an array of individually addressable electric field activatable sub-pixels;
b) at least one region of the array where the sub-pixels have different colors and grouped to make pixels for forming a full color display image; and
c) at least one other region of the array where the sub-pixels re all monochromatic thereby increasing the resolution of that region.

It is an advantage of the present invention that the localized increase in resolution can be achieved without reducing the line resolution of the lithography used to produce the complete display. The step and repeat artwork for making the sub-pixels can be the same for the full color and monochromatic regions of the display. A single display takes up less space than separate framed displays and the number of drive circuits for the individually addressable pixels is reduced in a single display.
FIG. 1 is a display with sections of the full color and monochromatic regions enlarged to show the sub-pixel colors;
FIG. 2 shows the pixel and sub-pixel pitches for the enlarged section of the full color region of FIG. 1;
FIG. 3 shows the pixel and sub-pixel pitches for the enlarged section of the monochromatic region of FIG. 1;
FIG. 4 shows an alternative pixel arrangement for the full color portions of the display in FIG. 1; and
FIG. 5 shows the corresponding alternative pixel arrangement for the monochromatic portion of the display in FIG. 1.

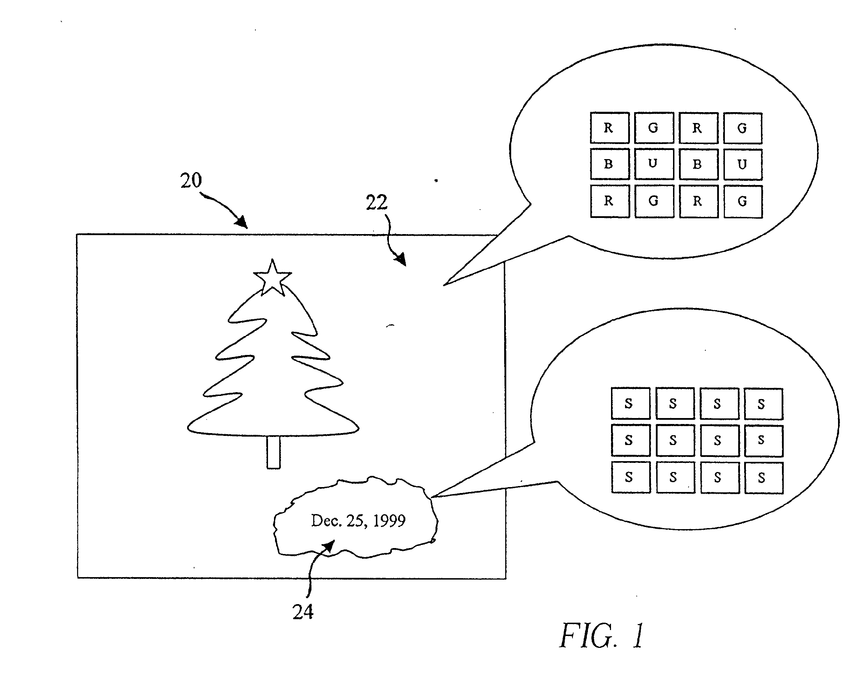

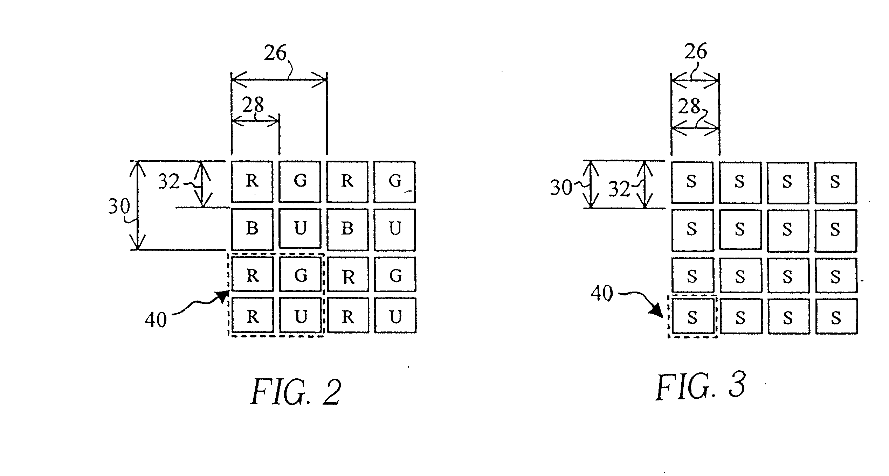

Turning now to FIG. 1 which shows a display 20 in accordance with the present invention that has two separate regions, one for full color image display 22 and one for monochromatic character display 24. It will be understood that, in order to practice the invention, there must be at least two separate regions of the display, one for full color display 22 and one for monochromatic character display 24. Included in FIG. 1 is an enlarged view of a portion of the full color region 22 of the display 20 wherein different colored sub-pixels; red R, green G, blue B, and an undefined sub-pixel region U are grouped to form pixels 40 for the full color display of images. This undefined sub-pixel region U can be left unused or can include a second red R, green G, or blue B sub-pixel. FIG. 1 also shows an enlarged view of a portion of the monochromatic region 24 for character display wherein the sub-pixels S are all the same color. The spacing of the sub-pixels are the same in both regions in the preferred embodiment shown in FIG. 1 as clearly shown in FIGS. 2 and 3 wherein the sub-pixel to sub-pixel spacing 28 in the x direction and the sub-pixel to sub-pixel spacing 32 in the y direction are the same. In this embodiment the sub-pixels S in the monochromatic region become pixels 40 and upon comparison with the pixels 40 in the full color region have two pixels 40 for each full color pixel 40 in both the x and y direction. Therefore, the resolution of a full color, for example, a (800X600) pixel display is increased to a (1600X800) pixel display in character display regions. This can be especially significant in video displays where the lower resolution is adequate for the constantly changing images, but higher resolution is needed for characters that update at a slower rate.

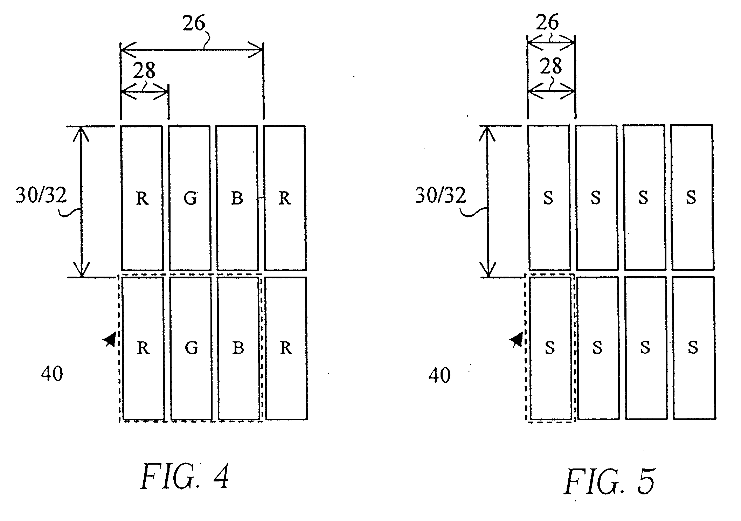

Turning now to FIG. 4 another embodiment is shown wherein red R, green G, and blue B sub-pixels that form full color pixels 40 in the full color portion 22 of the display 20 are arranged in a line in the x direction with pixel spacing 26 and sub-pixel spacing 28 and equal pixel 30 and sub-pixel 32 spacing in the y direction. FIG.5 then shows the equal sub-pixel 28 and pixel 26 spacing in the x direction and equal sub-pixel 32 and pixel 30 spacing in the y direction in the monochromatic region 24 of the display 20. In this case the resolution of the monochromatic region 24 in the x direction is three (3) times greater than that of the full color region 22. However, the pixel resolution is the same in the y direction in both regions.

Other embodiments are possible by rearranging the sub-pixel positions to give different increases in resolution in the x and y directions when comparing the pixel pitches in full color regions to that of the monochromatic regions.

## Claims

1. A display comprising:
a) an array of individually addressable electric field activatable sub-pixels;
b) at least one region of the array where the sub-pixels have different colors and grouped to make pixels for forming a full color display image; and
c) at least one other region of the array where the sub-pixels are all monochromatic thereby increasing the resolution of that region.

2. The display of claim 1 wherein the x and y spacing of the sub-pixels in all regions are the same so that the resolution of the monochromatic regions are greater than that of the full color regions.

3. The display of claim 2 wherein the electric field activatable sub-pixels are liquid crystal devices or organic light emitting diodes.

4. The display of claim 3 wherein the monochromatic regions are used to display characters.

5. The display of claim 4 wherein the monochromatic regions are used to display characters.

6. The display of claim 5 wherein the monochromatic regions are used to display characters.
